# EUROPEAN PATENT SPECIFICATION

(11) **EP 2 878 940 B1**
(45) Date of publication and mention of the grant of the patent: **26.02.2020**
(21) Application number: 14193354.9
(22) Date of filing: 14.11.2014
(51) Int. Cl.: G01L 9/00, G01L 19/06

(54) **MEMS pressure sensor field shield layout for surface charge immunity in oil filled packaging**
MEMS-Drucksensor-Feldabschirmungslayout für Oberflächenladungsimmunität in ölgefülltem Gehäuse
Revêtement de protection de zone de capteur de pression de systèmes microélectromécaniques pour l'immunité de charge de surface dans un emballage rempli d'huile

(30) Priority: 18.11.2013 US 201314082562
(43) Date of publication of application: 03.06.2015
(73) Proprietor: Sensata Technologies, Inc., Attleboro, MA 02703 (US)
(72) Inventor: McNeal, Mark P., Northborough, MA Massachusetts 01532 (US); Strott, Douglas B., Andover, MA Massachusetts 01810 (US); Greene, Stephen P., N. Scituate, RI Rhode Island 02857 (US)
(74) Representative: Abel & Imray

(56) References cited:
- JP-A- 2009 180 622
- US-A1- 2006 278 012
- US-A1- 2007 148 788

## Description

### BACKGROUND OF THE INVENTION

### 1. Field of the Invention

The invention disclosed herein relates to pressure sensors, and in particular to design of a pressure sensor to limit influence of surface charge accumulation in oil filled packages.

### 2. Description of the Related Art

Offset drift due to surface charge accumulation is a well-known phenomenon and common failure mode occurring in a wide variety of semiconductor devices. The failure mechanism involves device surface charge accumulation which drives formation of charge inversion layers. The inversion layers compromise otherwise electrically isolating junction states. Growth of the charge inversion layer permits parasitic current leakage through the epi-layer, resulting in sensing element offset drift. As with many other types of devices, pressure sensing elements are influenced by this phenomenon.

Present day designs for pressure sensing elements that include a field shield are susceptible to surface charge accumulation and exhibit severe offset drift due to sense element charging. This is especially the case when deployed in oil encapsulated package assemblies and applications.

In many package configurations, the pressure sensing element is encapsulated by a dielectric oil. The oil provides for coupling of external absolute or differential pressure inputs with the sense element. Unfortunately, this also serves to couple external, electrostatic charge residing on the package, or elsewhere, to the sensing surface of the pressure sensing element. Typically, charge coupling occurs through polar alignment of molecules in the oil in response to an external field, and associated space charge accumulation at an interface of the sense element and the oil. Consequently, comparatively large external static charge may be coupled to the sensing element via the molecular polarizability of the oil. Such charge may be residing on, for example, plastic housing assemblies used to package the sensing element or introduced to the housing by electrostatic discharge (ESD) to the plastic package. This high static charge is more than sufficient to cause severe output shift.

Thus, what are needed are methods and apparatus to improve the performance of pressure sensors encapsulated in an oil containing package.

US 2007/0143788 A1 discloses a semiconductor piezoresistive sensor, which is electrically connected with a circuit, that includes a semiconductor base, at least one piezoresistive element and a conductive layer. The semiconductor base includes a diaphragm and a base. The base is disposed adjacent to and around the diaphragm. The piezoresistive element is formed in the diaphragm and is electrically connected with the circuit. The conductive layer is formed on top of a non-conductive layer formed on the diaphragm and is provided with a voltage.

US 2006/0278012 discloses a semiconductor pressure sensor provided with a diaphragm that responds to the pressure of the fluid to be measured. The diaphragm includes a silicon substrate with piezoresistive elements, which together constitute a bridge circuit, being embedded therein, and a shield film for electromagnetic shielding formed on a surface of the silicon substrate at a side thereof at which the fluid to be measured is in contact with the silicon substrate. The shield film is electrically connected to the silicon substrate so as to have the same potential as that of the silicon substrate.

Japanese patent application no. JP-A-2009/180622 describes a piezoresistance type physical quantity sensor capable of enhancing a light blocking effect to piezoelements and obtaining an accurate output, and a method for manufacturing the same. Being composed of an impurity semiconductor layer formed by injecting an impurity to the surface of a diaphragm which is displaced by receiving pressure, the plurality of piezoelements which change the resistance value according to the displacement of the diaphragm are formed. On the upper part of each piezoelement, a metal film is placed in a facing position via an insulating layer and in a planar view the metal film is formed in a size projecting outside of the facing piezoelements.

### SUMMARY OF THE INVENTION

In one embodiment, a pressure sensing element is provided. The pressure sensing element includes a sensing sub-element disposed on a diaphragm, the element including: a contact via, and an interconnect disposed between the sub-element and the contact via;
a field shield disposed over the sub-element, the contact via and the interconnect, the field shield configured to reduce influence of charge accumulation on the sub-element during operation;
a field shield circuit configured to substantially eliminate influence of external charge on the sub-element during operation by applying a potential to a substrate of the diaphragm and the field shield;
a high-pressure port and a low-pressure port coupled to opposed sides of the diaphragm, the low-pressure port coupled via a reservoir of oil to a side of the diaphragm opposed from a pressure environment; and
a passivation layer disposed between the field shield and the sub-element.

In another embodiment, a pressure sensor is provided. The pressure sensing element includes a sensing sub-element disposed on a diaphragm, the element including a shield disposed over the sub-element and configured to substantially eliminate influence of external charge on the sub-element during operation.

The sub-element may include at least one piezoresistive element. The sub-element may be implanted into the diaphragm. The field shield may be configurable to substantially eliminate signal leakage within the sensing element. The field shield may be disposed over the sub-element by deposition and photolithography. Sources of the external charge may include at least one of oil in which the sensing element is at least partially immersed and other components surrounding the sensing element.

In another embodiment, a method for fabricating a pressure sensing element is provided. The method includes selecting a pressure sensing element including a sub-element disposed on a diaphragm; disposing a field shield over the sub-element, a contact via and an interconnect disposed between the sub-element and the contact via, the field shield configured to substantially eliminate influence of external charge on the sub-element during operation by operation of a field shield circuit configured to apply a potential to a substrate of the diaphragm and the field shield; disposing a passivation layer between the field shield and the sub-element; and forming a high-pressure port and a low-pressure port coupled to opposed sides of the diaphragm, the low-pressure port coupled via a reservoir of oil to a side of the diaphragm opposed from the pressure environment.

In another embodiment, the method for fabricating a pressure sensing element is provided. The method includes selecting a pressure sensing element including a sub-element disposed on a diaphragm; and disposing a shield over the sub-element and configuring the shield to substantially eliminate influence of external charge on the sub-element during operation.

Some embodiments comprise covering the interconnect, the contact via and the sub-element with a metallic (or electrically conducting) composition to limit the influence of the external charge.

In a further embodiment, a pressure sensor is disclosed. The pressure sensor includes a pressure sensing element including a sensing sub-element disposed on a diaphragm, the element including a shield disposed over the sub-element, a contact via and an interconnect disposed between the sub-element and the contact via, the field shield configured to substantially eliminate influence of external charge on the sub-element during operation by operation of a field shield circuit configured to apply a potential to a substrate of the diaphragm and the field shield; and a port for exposing the pressure sensing element to a pressure environment. At least another pressure sensing element may be included in the pressure sensor.

In a further embodiment, a pressure sensor is disclosed. The pressure sensor includes a pressure sensing element comprising a sensing sub-element disposed on a diaphragm, the element comprising a shield disposed over the sub-element and configured to substantially eliminate influence of external charge on the sub-element during operation; and a port for exposing the pressure sensing element to a pressure environment. At least another pressure sensing element may be included in the pressure sensor

The pressure sensor may include another port and another pressure sensing element. A top side of the diaphragm and a back side of the port may be coupled by a reservoir of oil. Measurements of differential pressure may span a range of between about 0.2 bar and 1 bar. The sensor may be configured for measuring differential pressure across a Venturi flow tube. The sensor may be configured for measuring mass air flow.

### BRIEF DESCRIPTION OF THE DRAWINGS

The features and advantages of the invention are apparent from the following description taken in conjunction with the accompanying drawings in which:
FIG. 1 is an isometric diagram depicting aspects of an exemplary pressure sensing element according to the teachings herein;
FIG. 2 is an isometric diagram depicting aspects of a pedestal for the pressure sensing element of FIG. 1;
FIGS. 3 and 4 are isometric diagrams depicting aspects of a silicon die for the pressure sensing element of FIG. 1;
FIG. 5 is a cutaway isometric diagram of the pressure sensing element of FIG. 1;
FIG. 6 is a composite cut-away view of a prior art sensing element;
FIG. 7 is a top down view of the prior art sensing element of FIG. 6;
FIG. 8 is an illustration depicting charge collection phenomena for the prior art sensor of FIGS. 6 and 7;
FIG. 9 is a composite cut-away view of the sensor of FIG. 1;
FIG. 10 is a top down view of the pressure sensing element of FIG. 1;
FIG. 11 is a schematic representation of an electrical circuit for the pressure sensing element of FIG. 1;
FIG. 12 is a cut-away view of a portion of the top view shown in FIG. 10;
FIG. 13 is an illustration depicting immunity of the sensor of FIG. 1 from the charge collection phenomena for the prior art sensor of FIGS. 6 and 7;
FIG. 14 is an isometric view of a pressure sensor that includes pressure sensing elements as shown in FIG. 1;
FIG. 15 is a cutaway view of the pressure sensor depicted in FIG. 14;
FIG. 16 is a schematic view depicting an application of the pressure sensor depicted in FIG. 1; and
FIG. 17 is a graph depicting comparative performance of sensing elements.

### DETAILED DESCRIPTION OF THE INVENTION

Disclosed herein are methods and apparatus for limiting the influence of surface charge or large static charge accumulation that may cause signal offset in a pressure sensor. Sources of the extraneous charge may include packaging of the sensing element. Advantageously, this generally results in immunity against drift in output data from the sensor.

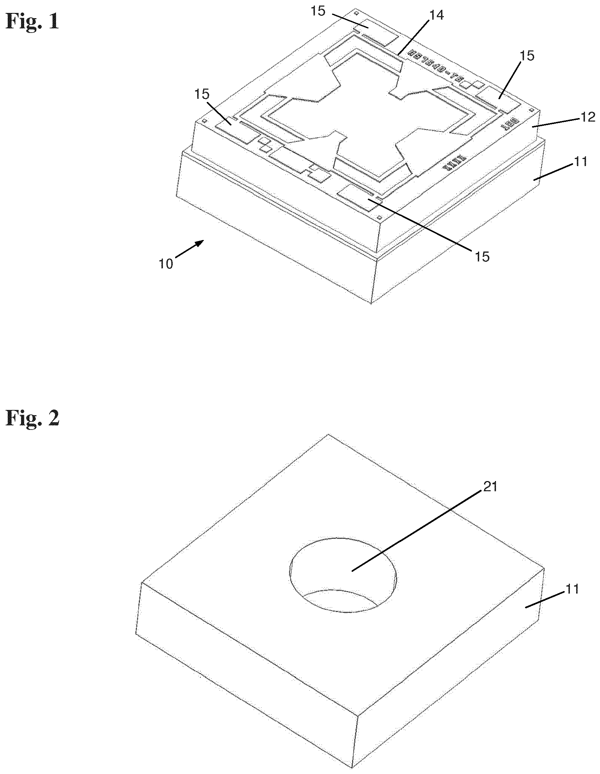

Referring now to FIG. 1, there is shown a pressure sensing element 10 according to the teachings herein. In this embodiment, the pressure sensing element 10 includes a pedestal 11 as a base to the pressure sensing element 10. The pedestal 11 may be formed of a suitable material such as glass. Disposed on top of the pedestal 11 is a silicon die 12. The silicon die 12 may be bonded to the pedestal 11 using techniques as are known in the art. The silicon die 12 is host to a circuit 14. Included in the circuit 14 is a plurality of bond pads 15. The bond pads 15 provide for electrical connection of the circuit 14 for the pressure sensing element 10 with external components. Generally, the external components provide for powering and receiving data from the pressure sensing element 10 and processing the data.

Referring to FIG. 2, a perspective view of an embodiment of the pedestal 11 is shown. In this example, other components of the pressure sensing element 10 have been omitted such that features of the pedestal 11 may be better presented. In this example, the pedestal 11 includes a central thruway 21 that provides a pressure port for sampling pressure. Accordingly, the thruway 21 is also referred to herein as a "port" 21. The port 21 may be provided in a variety of forms. For example, it is not necessary that the thruway 21 be provided as a singular, cylindrical penetration through a center of the pedestal 11 as shown. In one embodiment, the thruway 21 includes a plurality of smaller perforations through a thickness of the pedestal 11. In another embodiment (not shown), the central thruway 21 may be omitted or terminate at some depth in the glass, forming a cavity in conjunction with silicon die 12. In this embodiment, the cavity may be evacuated or backfilled to a fixed reference pressure, configuring sensing element 10 for absolute pressing sensing.

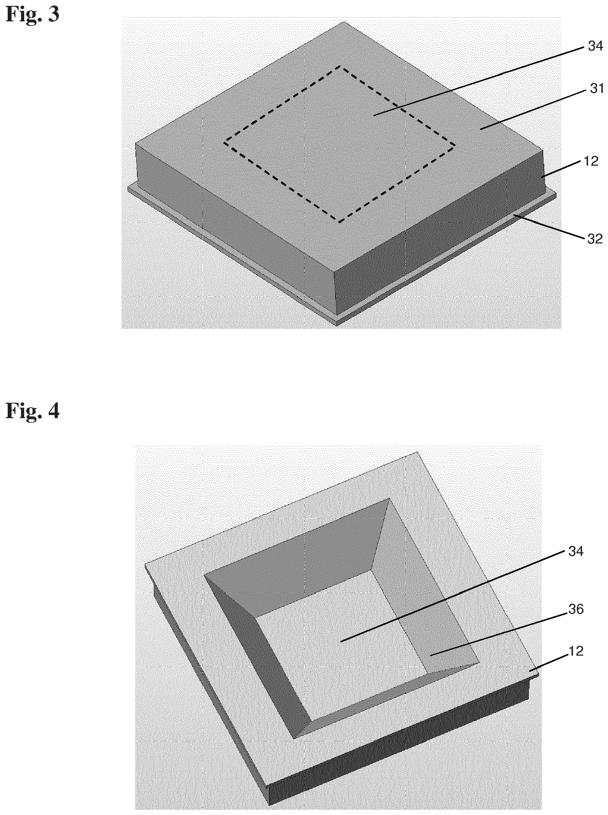

Referring now to FIG. 3, a perspective view of an embodiment of the silicon die 12 is shown. In this example, other components of the pressure sensing element 10 have been omitted such that features of the silicon die 12 may be better presented. In this example, the silicon die 12 includes an optional flange 32. The flange 32 may be useful for assembly of the pressure sensing element 10. For example, during assembly, mechanical pressure may be applied to the flange 32 such that an underlying adhesive is evenly distributed and compressed onto the pedestal 11. The silicon die 12 includes a top 31. Generally, the top 31 includes a substantially planar surface. Within a central portion of the top 31 is a diaphragm 34. Generally, the diaphragm 34 will flex according to pressure experienced by the pressure sensing element 10.

Referring now to FIG. 4, a perspective view of an underside of the silicon die 12 is shown. In this example, the silicon die 12 includes a cavity 36. When the silicon die 12 is mated with the pedestal 11, the cavity 36 results in a chamber. Generally, the cavity 36 is defined by a wall (such as where the cavity 36 is cylindrical in form), or a plurality of walls (as shown in FIG. 4). The diaphragm 34 is defined by a base of the cavity 36, and may be of a substantially uniform thickness.

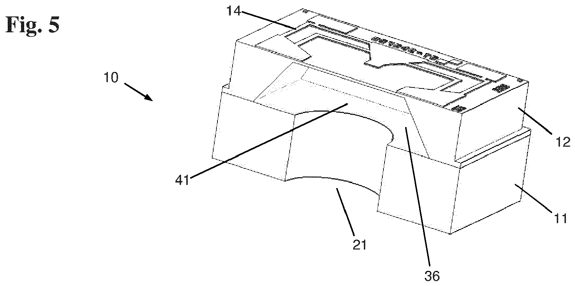

Referring now to FIG. 5, a semi-transparent perspective view of the pressure sensing element 10 is shown. In this illustration, it may be seen that the cavity 36 of the silicon die 12 forms a chamber 41 when the silicon die 12 is mated with or joined to the pedestal 11.

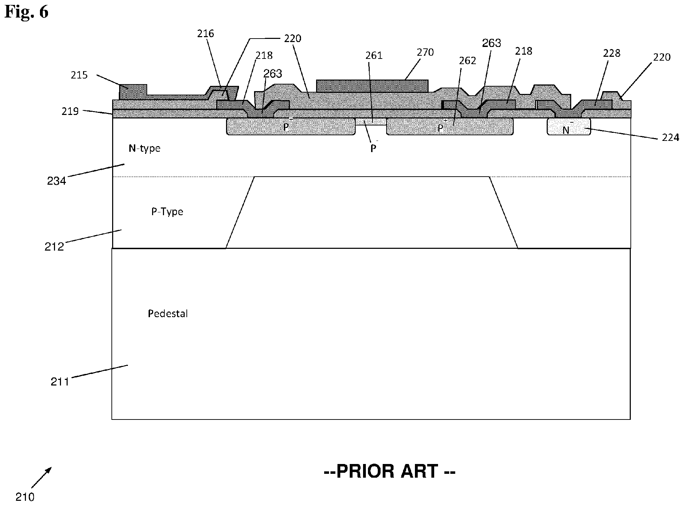

In order to provide some context for the teachings herein, aspects of a prior art sensor are introduced and discussed with regard to FIGS. 6-9.

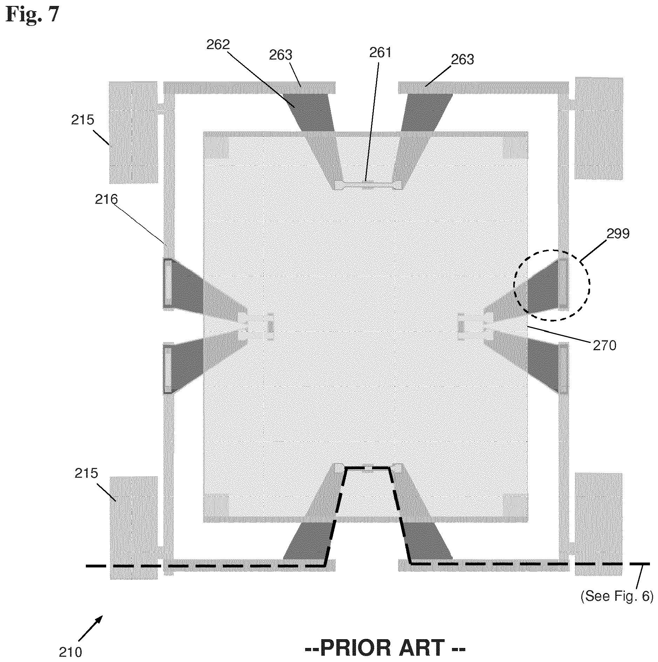

Referring now to FIG. 6, a composite cross-section of a prior art sensor to 10 is shown. Refer also to FIG. 7, where a dashed line towards the bottom of the diagram indicates the portions of the cross section of the prior art sensor 210 that are depicted.

The exemplary prior art sensor 210 includes pedestal 211. Disposed on top of the pedestal 211 is silicon die 212. In an upper most portion of the silicon die 212 is the diaphragm 234. In this embodiment, a lower portion of the silicon die 212 is fabricated of P type semiconductor material, while the diaphragm 234 is fabricated from N type semiconductor material. In other embodiments, the lower portion of the silicon die 212 is fabricated of N type semiconductor material and the diaphragm 234 is fabricated from the same N type material. Implanted within the diaphragm 234 are interconnects 262. The interconnects 262 are fabricated of a P+ type of semiconductor material. P+ refers to highly acceptor doped region of semiconductor to achieve suitably low resistivity (high conductivity). The interconnects 262 provide for connection to a sensing sub-element 261. In this example, the sensing sub-element 261 is of a P- type of semiconductor material. Prefers to lower acceptor doped region of semiconductor as required to achieve desired resistance and piezoresistive coefficient. A sensor contact via 263 provides electrical contact to each of the respective interconnects 262. The electrical contact is accomplished with sensor contact 218.

A first passivation layer 219 provides for electrical separation of the sensor contact metal 218 from other components. Each sensor contact via 263 is in electrical communication with a bridge trace 216. In turn, the bridge trace 216 is connected to at least one bond pad 215. The at least one bond pad 215 provides for external electrical connections. A bias via 224 provides for electrical contact with the diaphragm 234. The bias via 224 is electrically connected to a bias contact 228. A top passivation layer 220 may be disposed over the first passivation layer 219, the sensor contacts 218, the bridge trace 216, and at least a portion of the bias contact 228.

Disposed over a portion of the prior art sensor 210, is a partial field shield 270. Generally, the partial field shield 270 provides for application of an electric potential that limits susceptibility to surface charge accumulation in particular environments. Exemplary environments include oil filled environments.

When the prior art sensor 210 is energized, a voltage, V, is applied to the bond pad 215. Current, /, flows to a first sensor contact 218 and into a first one in a pair of interconnects 262. The current passes through the sensing sub-element 261, onto the second one in a pair of interconnects 262 and out through a second sensor contact 218. (As a matter of convenience, an assembly of a first interconnect 262, the sensing sub-element 261, and the second interconnect 262 is referred to as a "resistive bridge" and by other similar terms). Flexing of the diaphragm 234 causes a change in the resistance of the sensing sub-element 261, and therefore a change in the signal at the second sensor contact 218.

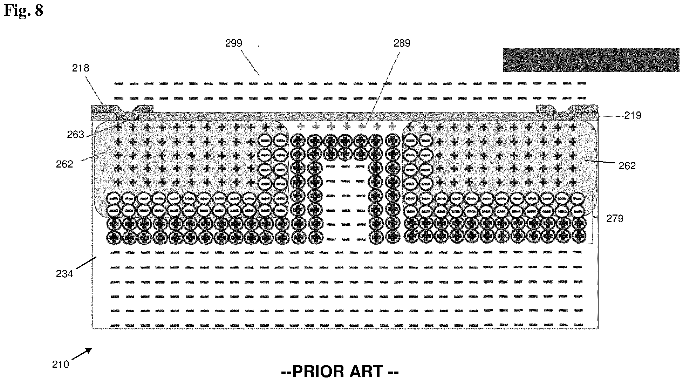

Generally, each interconnect 262 includes highly doped P type material, while the sensing sub-element 261 includes lowered doped P type material. Accordingly, during operation, a P/N junction forms (refer also to FIG. 8, wherein the P/N junction 279 is shown). The P/N junction 279 provides electrical isolation of the resistive bridge from the N type semiconductor material 234. Thus, leakage of current, *I*, and therefore signal loss is reduced.

Unfortunately, design of the prior art sensor 210 is such that the partial field shield 270 does not completely cover sensing components. Among other things, designs for prior art sensors 210 have been such that enhancement of coverage provided by the partial field shield 270 would cause, at least in some cases, short-circuiting of the partial field shield 270 with the resistive bridge.

As a result, the partial field shield 270 has left at least a portion of each resistive bridge exposed to the sensing environment. In some embodiments, there has been a limited interference as a result. However, in some other embodiments, such as where the sensing environment is filled with oil, signal leakage occurs. Referring now to FIG. 7, it may be seen that signal leakage may arise in the unshielded region 299. Of course, it should be recognized that the unshielded region 299 shown in FIG. 7, is merely for one interconnect 262 out of the eight (8) interconnects 262 shown in this prior art sensor 210. Accordingly, in some sensing environments, signal leakage may have a substantial impact on performance of the prior art sensor 210.

Refer now also to FIG. 8 for a better understanding of this phenomena. FIG. 8 depicts a composite cross-sectional view of a portion of the prior art sensor 210, wherein the view is a close-up of the composite view provided in FIG. 6.

In FIG. 8, there is shown a negative surface charge that has accrued over the top of the prior art sensor 210. Generally, each interconnect 262, both of which are P+ type of semiconductor material, contains a substantial number of acceptors in a positive acceptor state. Similarly, the diaphragm 234, which is of an N type of semiconductor material, contains a substantial number of donors in a negative donor state. When the prior art sensor 210 is energized, the depletion region 279 forms at the P/N junction between each interconnect 262 and the N type semiconductor material 234 as the charged minority ions migrate within these components. Quite frequently, such as when the prior art sensor 210 is operated in an oil filled environment, polar molecules of the environment will align to cause the high negative surface charge that has accrued over the top of the prior art sensor 210. As a result the depletion region 279 grows, as minority charge carriers in the N type semiconductor 234 migrate to the interface creating an inversion layer 289, thus creating a current leakage path between P+ regions 262. With a current leakage path, device output drift ensues.

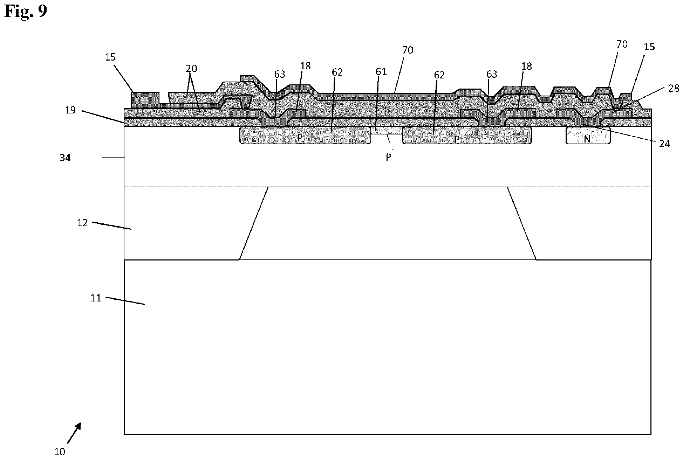

Turning to FIGS. 9-13, further aspects of the sensor 10 (shown in FIGS. 1-5) are shown. The sensor 10 overcomes the problems associated with the current leakage path of the prior art sensor 210 by, among other things, use of the field shield 70.

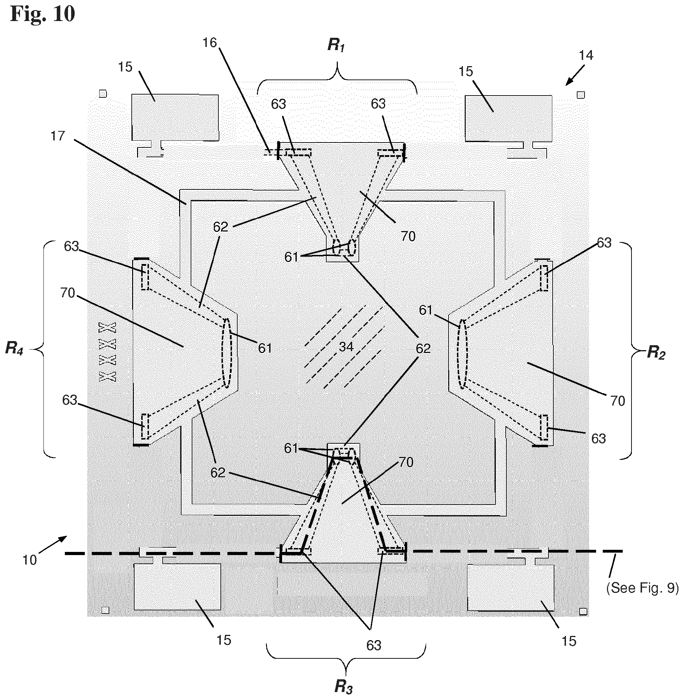

In FIG. 9, a composite cross-section of the sensor 10 is shown. Refer also to FIG. 10, where a dashed line towards the bottom of the diagram indicates the portions of the cross section of the sensor 10 that are depicted. Note that in FIG. 10, four sensing elements are shown. Each sensing element is denoted one of *R₁, R₂, R₃,* and *R₄*. Collectively, the four (4) sensing elements, *R₁, R₂, R₃,* and *R₄*, provide for the sensor 10. It should be understood that the sensor 10 may include additional or fewer sensing elements, and that grouping selected may be arranged in any manner determined appropriate to provide a desired function. Further, it should be understood that the circuit devices may be of any geometry (for example, shape, profile, width, thickness and the like) deemed appropriate. FIG. 9 provides a composite cross-section of one sensing element, *R₃*.

In the exemplary embodiment of the sensor 10, a pedestal 11 is included. Disposed on top of the pedestal 11 is silicon die 12. In an upper most portion of the silicon die 12 is the diaphragm 34. In this embodiment, a lower portion of the silicon die 12 is fabricated of P type semiconductor material, while the diaphragm 34 is fabricated from N type semiconductor material. In some other embodiments, the lower portion of the silicon die 12 is fabricated of N type semiconductor material and the diaphragm 34 is fabricated from the same N type material. Implanted within the diaphragm 34 are interconnects 62. The interconnects 62 are fabricated of a P+ type of semiconductor material. The interconnects 62 provide for connection to a sensing sub-element 61. In this example, the sensing sub-element 61 is of a P- type of semiconductor material. A sensor contact via 63 provides electrical contact to each of the respective interconnects 62. The electrical contact to each interconnect 62 is accomplished with a respective sensor contact 18.

The sensing sub-elements 61 may include any type of component that provides for measuring a deflection or distortion of the diaphragm 34. For example, the sensing sub-elements 61 may include piezoresistive elements formed by light, positively doped (P⁻) silicon. The sensing sub-elements 61 are electrically coupled to respective electrical contact vias 63 by respective highly positively doped (P⁺) solid-state interconnects 62. The electrical contact vias 63 and interconnects 62 may be fabricated from semiconductor materials such as positively doped semiconductor materials. At least a portion of the circuit 14 may be disposed onto the top of the silicon die 12 through techniques such as photolithography, by deposition, or by other techniques deemed appropriate. The electrical contact vias 63 and interconnects may be implanted in the material of the silicon die 12, with at least a portion of the circuit 14 disposed there over. A respective field shield 70 is disposed over the sensing sub-elements 61, the electrical contact vias 63, and the interconnects 62. The respective field shield 70 is disposed over and electrically insulated from sub-elements 61, the electrical contact vias 63, and the interconnects 62, by a thin passivation film of suitable material, typically vapor deposited Si₃N₄ and/or thermally grown SiO₂.

A first passivation layer 19 provides for electrical separation of each of the sensor contact 18 from other components. Each sensor contact via 63 is in electrical communication with a bridge trace 16. In turn, the bridge circuit 16 is connected to at least one bond pad 15. The at least one bond pad 15 provides for external electrical connections. A bias via 24 provides for electrical contact with the diaphragm 34. The bias via 24 is electrically connected to a bias contact 28. A top passivation layer 20 may be disposed over the first passivation layer 19, the sensor contacts 18, the bridge trace 16, and at least a portion of the bias contact 28.

Disposed over the electrical components within the sensor 10, is the field shield 70. Generally, the field shield 70 provides for shielding of the entire resistive bridge from the effects of negative surface charge that has accrued external to the sensor 10. Among other things, the field shield 70 provides for application of an electric potential that limits susceptibility to surface charge accumulation in particular environments. Exemplary environments include oil filled environments.

When the sensor 10 is energized, a voltage, V, is applied to the bond pad 15. Current, /, flows to a first sensor contact 18 and into a first interconnect 62 in a pair of the interconnects 62. The current passes through the sensing sub-element 61, onto a second interconnect 62 and out through a second sensor contact 18. (As a matter of convenience, an assembly of the first interconnect 62, the sensing sub-element 61, and the second interconnect 62 is referred to as a "resistive bridge" and by other similar terms). Flexing of the diaphragm 34 causes a change in the resistance of the sensing sub-element 61, and therefore a change in the signal at the second sensor contact 18.

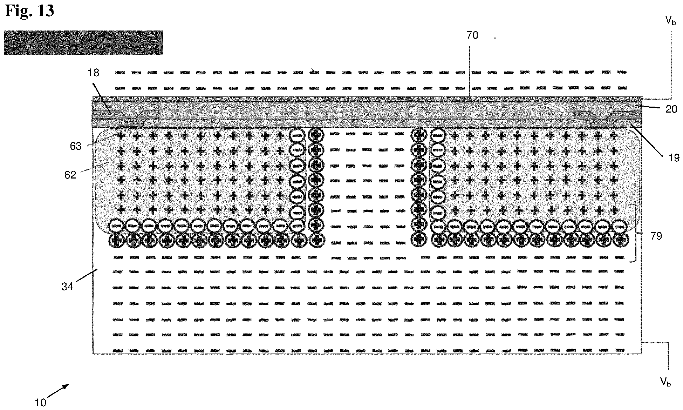

Generally, each interconnect 62 includes highly doped P type material, while the sensing sub-element 61 may include a lower level of P type material. During operation, a P/N junction forms (refer also to FIG. 13, wherein a P/N junction 79 is shown). Advantageously, the P/N junction 79 provides electrical isolation of the resistive bridge from the N type of material 34. Thus, leakage of current, /, and therefore signal leakage is avoided.

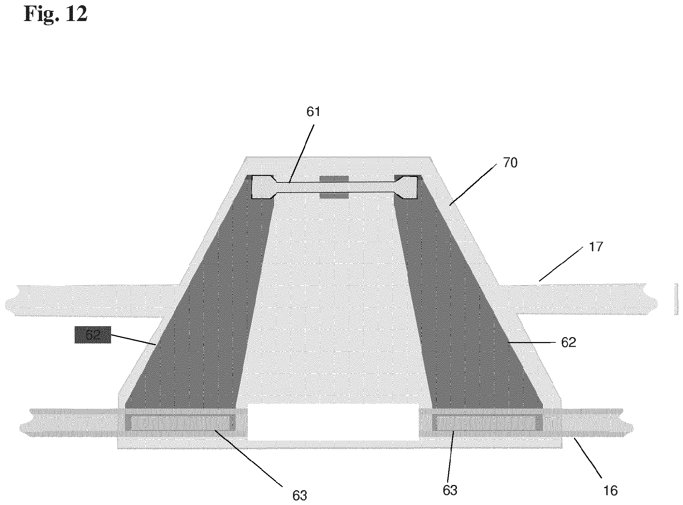

As shown in FIGS. 10 and 12, a field shield circuit trace 17 extends across portions of the diaphragm 34. The field shield circuit trace 17 provides for electrical connection of a first field shield 70, with a second field shield 70 and so on.

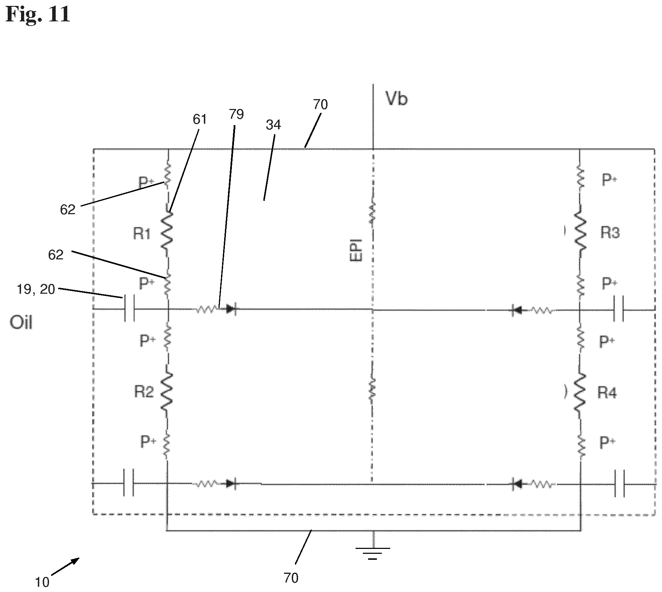

Refer now also to FIG. 11 wherein electrical schematic depiction of the sensor 10 is shown. In this example, the capacitor symbol represents the passivation layers 19, 20, for each of the sensing elements *R₁, R₂, R₃,* and *R₄*. The reverse biased junction diode represents the depletion region 79, for each of the sensing elements *R₁, R₂, R₃,* and *R₄*.

As shown in FIG. 12, the bridge circuit 16 and field shield circuit trace 17 are isolated by physical separation with passivation disposed therebetween. Each field shield 70 strategically covers all active areas of a respective sensing element. That is, each field shield 70 fully covers each sensor contact via 63, each interconnect 62, and each sensing sub-element 61. By use of the field shield 70, formation of the inversion layer that occurs in the prior art sensor 210 is avoided.

As shown in FIG. 13, negative surface charge that has accrued over the top of the sensor 10 does not perturb operation of the sensor 10. That is, operation of the field shield 70 by applying voltage, V, to the field shield 70 and the N Type layer 34 causes a reduction in the depletion region 79 and substantially eliminates the inversion layer 289 that is formed in the prior art sensor 210.

This configuration has proven robustness under extremely high static charge build-up on surface of sense element.

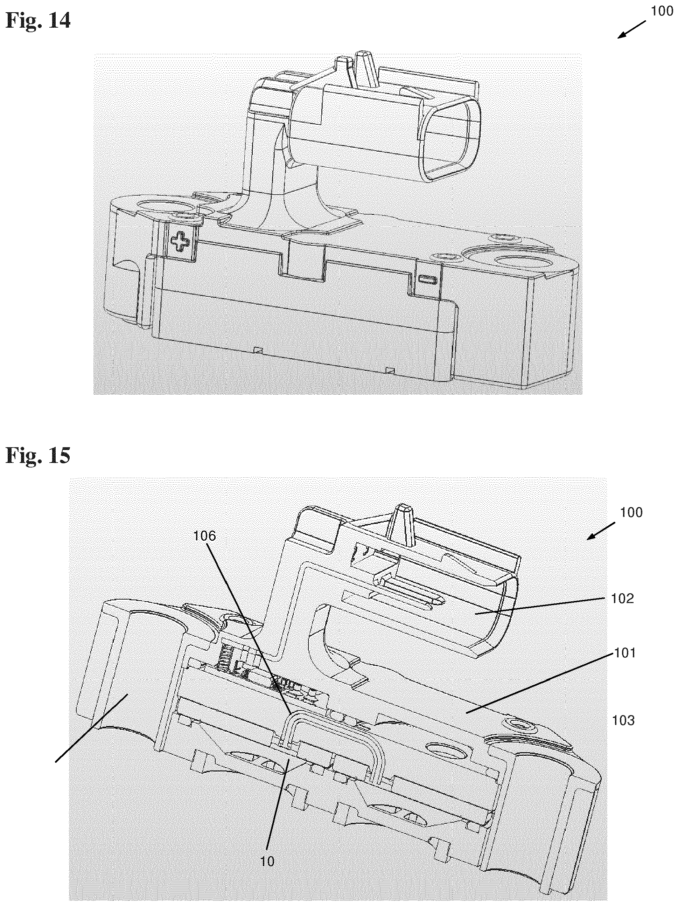

Referring now to FIG. 14, there is shown an exemplary pressure sensor 100. The pressure sensor 100 makes use of pressure sensing element 10 as disclosed herein.

FIG. 15 is a cutaway view of the illustration of FIG. 14. The exemplary pressure sensor 100 includes a body 101. The body 101 includes a port 102. Generally, the port 102 houses connectors for providing external connection to electrical systems. The body 101 includes at least one mount 103. The at least one mount 103 is useful for securing the pressure sensor 100 in place. In this example, the pressure sensor 100 includes a high-pressure port 104 and a low-pressure port 105. Pressure is communicated between the high-pressure port 104 and the low-pressure port 105 by a tube 106. Generally, the tube 106 is filled with oil. Disposed at the high-pressure end of the tube 106 is a respective pressure sensing element 10.

The tube 106 may be considered as an embodiment of a reservoir of oil. The reservoir provides for coupling pressure port 21 of a pressure sensing element 10 to the low-pressure port 105. In this example, the reservoir of oil is provided in an extended tube or column. However, the reservoir may be of any geometry deemed appropriate for coupling environmental pressure to sensing element 10. For absolute pressure configuration port 21 forms reference cavity, with pressure coupled to sensing element top side 31. For relative or differential pressure sensing, the reservoir provides pressure coupling to central thruway 21, with at least another pressure port coupled to the opposing side of sensing element 10 as appropriate for determining differential pressure (i.e., pressurewise coupling). A high-pressure port 104 couples high pressure to the sensing element 10 top side diaphragm 34 for the configuration described in this disclosure.

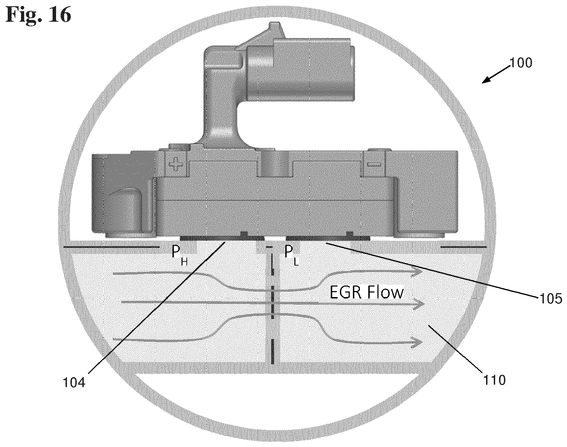

Referring now also to FIG. 16 where an embodiment of the exemplary pressure sensor 100 is shown installed. In this example, the pressure sensor 100 is installed on a pressurized environment 110. The pressurized environment 110 includes a flow (in this illustration, from left to right). An exemplary pressurized environment 110 includes exhaust gas recirculation flow. By enabling measurement of pressure in the high-pressure port 104 as well as pressure in the low-pressure port 105, a system making use of the pressure sensor 100 may be configured for making assessments of common pressure, differential pressure, flow dynamics and other related quantities.

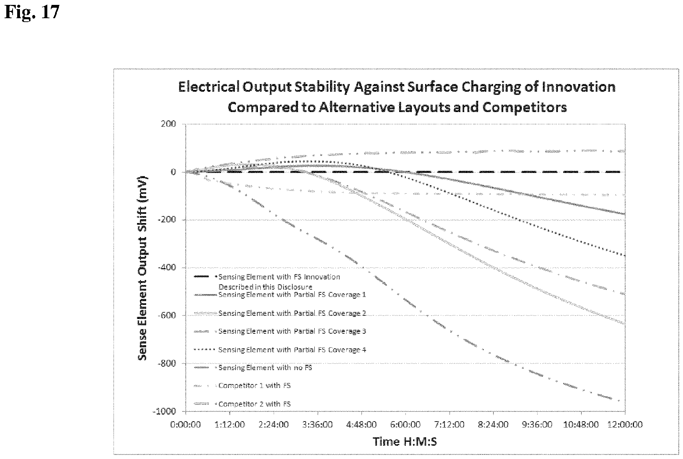

FIG. 17 provides a graphical depiction of performance for embodiments of pressure sensors. In the embodiment designed according to the teachings presented herein, the sensor did not exhibit any drift at all. In contrast, drift for prior art designs ranged from moderate to substantial.

More specifically, and by way of non-limiting example, measurement of pressure drop across a Venturi flow tube enables calculation of mass airflow. In some embodiments, pressure differential that may be measured ranges from about 0.2 bar to about 1 bar. Common mode measurement of pressure range as high as about 8 bar.

Some additional aspects of the pressure sensing element 10 are now introduced.

Generally, each field shield may be extended to fully cover each implanted device circuit, contact vias and areas of the metal interconnects, as necessary to prevent formation of low resistance inversion channel between P+ interconnects. Typical prior art designs limit field shield coverage on the sensing element to the piezoresistive bridge and portions of the highly doped P+ interconnects, whereby uncovered implanted areas remain susceptible to charging and formation of inversion layer. Accordingly, design of the circuit devices may be modified to accommodate the piezoresistive elements, and to fully cover P+ doped interconnects, electrical contact vias, and metal interconnects, as needed for complete immunity against surface charging.

Specific to this innovation, the field shield metal, layout and method of deposition provide low membrane stress coupling for superior device performance of low pressure (less than about 1 Bar) die. The metal may be of any type common to the industry, including elemental, alloys or compound mixture. In practice, the field shield is isolated from the first metal layer by an intervening layer of passivation, for instance, silicon nitride, with contact vias to the diaphragm. The orientation and layout of sensing sub-elements, contact vias, and interconnects are such that area of metal coverage on diaphragm is minimized. Minimizing metal coverage insures minimum stress coupling from the metal field shield to sensing element diaphragm of low pressure die. Depositing films sufficiently thin insures maximum device sensitivity. Metal film thickness used is generally about 100 nm to about 50 nm or less. Thicker metals may be used as well. The field shield arrangement described herein may also be deployed on sensing elements of any pressure range (greater than about 1Bar) die. In particular, completely covering the diaphragm of a low pressure die with a thick metal or other material degrades performance. Thicker films shift the neutral stress axis away from the piezoresitive elements, therefore lowering sensitivity; and introduce higher mechanical stress coupling to the membrane, therefore impacting accuracy and over-life stability. In operation, an equivalent potential is applied to both field shield layer and the diaphragm, generally bridge voltage, V_{b}, to maintain a neutral field between the field shield metal and the diaphragm for environmental conditions that may be encountered during normal operation. The maintenance of the neutral field across all active areas, even with very high accumulation of surface charge, ensures long term output stability of the device. Bench tests used to induce sense element charging and output drift confirm superior performance of the techniques disclosed herein.

As discussed herein, terminology relating to "electrical separation" generally refers to conditions adequate for maintaining a neutral field between electrical components. In some embodiments, electrical separation may also be referred to as electrical isolation. Electrical separation may be realized by application of intervening layers such as a passivation layer. In some embodiments, electrical separation may rely upon (or additionally make use of) biasing of a circuit element.

As discussed herein, the term "contact metal" generally refers to metal used for contact via regions of highly doped semiconductor materials. Contact metal may be any metal typical of industry, or otherwise deemed appropriate for use. The term "passivation" generally refers to an electrical isolation barrier separating different metal layers or separating metal from semiconductor. Materials used for a passivation may include oxide and/or nitride or other material common to industry. Passivation may also be provided as a physically protective barrier. As discussed herein, the term "bond pad" generally refers to a metal bond pad used to provide for wire bond or other suitable electrical contact to the device. In general, the bond pad is maintained at a desired bias voltage, *V_{b},* while potential at other bond pads 15 is determined by the resistance of piezoresistors 61.

In some embodiments, the field shield is provided as a film of conductive metal or other material common to the industry. In general, P+ type of materials refer to highly acceptor doped region of semiconductor to achieve high conductivity; and, N+ type of materials refer to highly donor doped region of semiconductor to achieve high conductivity. An N+ contact via includes a metal-to-semiconductor contact formed in N-type semiconductor region, where contact resistance is low and ohmic. In the examples provided herein, the N+ contact via is at maintained at a desired bias voltage, *V_{b}.* In the examples provided herein, the P+ contact via includes a metal-to-semiconductor contact formed in P-type semiconductor region, where contact resistance is low and ohmic.

As discussed herein, P- type of semiconductor material refers to moderate or lower acceptor doped region of semiconductor material. P- type semiconductor material may be used to form a piezoresistor of desired resistance. As discussed herein, N-type semiconductor material generally refers to donor doped bulk semiconductor material that forms the flexible diaphragm of the pressure sensor. As discussed herein, P-Type of semiconductor material generally refers to acceptor doped bulk semiconductor material. In some embodiments, the pedestal is formed from glass.

As discussed herein, "substantially eliminating influence of external charge on the sensing element" generally refers to reducing influence of charge accumulation on output of the sensing element. For example, substantially eliminating influence of external charge results in reductions of output drift to levels that are within acceptability for a particular design, or from the perspective of a designer, manufacturer, user, or other similarly interested person. Alternatively, "substantially" eliminating influence of external charge (and other related terminology) results in reductions of output drift to levels that exceed the performance of competitive designs.

Components described herein may be fabricated in any manner deemed appropriate. For example, semiconductor materials may be grown by deposition, removal, patterning, and other similar techniques. Exemplary techniques include, without limitation, physical vapor deposition (PVD), chemical vapor deposition (CVD), electrochemical deposition (ECD), molecular beam epitaxy (MBE) and atomic layer deposition (ALD). Photolithography, etching and other techniques may be used as appropriate.

Various other components may be included and called upon for providing for aspects of the teachings herein. For example, additional materials, combinations of materials and/or omission of materials may be used to provide for added embodiments that are within the scope of the teachings herein.

When introducing elements of the present invention or the embodiment(s) thereof, the articles "a," "an," and "the" are intended to mean that there are one or more of the elements. Similarly, the adjective "another," when used to introduce an element, is intended to mean one or more elements. The terms "including" and "having" are intended to be inclusive such that there may be additional elements other than the listed elements.

While the invention has been described with reference to exemplary embodiments, it will be understood by those skilled in the art that various changes may be made and equivalents may be substituted for elements thereof without departing from the scope of the invention, as defined by the appended claims. In addition, many modifications will be appreciated by those skilled in the art to adapt a particular instrument, situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

## Claims

1. A pressure sensing element (10) comprising a sensing sub-element (61) disposed on a diaphragm (34), the element comprising:
a contact via (63), and an interconnect (62) disposed between the sub-element and the contact via;
a field shield (70) disposed over the sub-element, the contact via and the interconnect, the field shield configured to reduce influence of charge accumulation on the sub-element during operation;
a field shield circuit configured to substantially eliminate influence of external charge on the sub-element during operation by applying a potential to a substrate of the diaphragm and the field shield;
a high-pressure port (104) and a low-pressure port (105) coupled to opposed sides of the diaphragm, the low-pressure port coupled via a reservoir (106) of oil to a side of the diaphragm opposed from a pressure environment; and
a passivation layer (19, 20) disposed between the field shield and the sub-element.

2. The sensing element of claim 1, wherein the sub-element comprises at least one piezoresistive element.

3. The sensing element of claim 1, wherein the sub-element is implanted into the diaphragm (34).

4. The sensing element of claim 1, wherein the field shield is configurable to reduce influence of charge accumulation within the sensing element.

5. The sensing element of claim 1, wherein the field shield is disposed over the sub-element by deposition and photolithography.

6. The sensing element of claim 1, wherein sources of the external charge comprise at least one of oil in which the sensing element is at least partially immersed and other components surrounding the sensing element.

7. A pressure sensor comprising:
the pressure sensing element of any one of claims 1 to 6; and
a port for exposing the pressure sensing element to a pressure environment.

8. The pressure sensor as in claim 7, comprising another port and another pressure sensing element.

9. The pressure sensor as in claim 8, wherein a top side of the diaphragm and a back side of the port are coupled by a reservoir of oil.

10. The pressure sensor as in claim 8, wherein measurements of differential pressure span a range of between about 0.2 bar and 1 bar.

11. The pressure sensor as in claim 8 configured for measuring differential pressure across a Venturi flow tube.

12. The pressure sensor as in claim 8 configured for measuring mass air flow.

13. A method for fabricating a pressure sensing element, the method comprising:
selecting a pressure sensing element comprising a sub-element disposed on a diaphragm;
disposing a field shield over the sub-element, a contact via and an interconnect disposed between the sub-element and the contact via, the field shield configured to reduce influence of charge accumulation on the sub-element during operation by operation of a field shield circuit configured to apply a potential to a substrate of the diaphragm and the field shield;
disposing a passivation layer between the field shield and the sub-element; and
forming a high-pressure port and a low-pressure port coupled to opposed sides of the diaphragm, the low-pressure port coupled via a reservoir of oil to a side of the diaphragm opposed from the pressure environment.

14. The method as in claim 13, comprising covering the interconnect, the contact via and the sub-element with a metallic (or electrically conducting) composition to limit the influence of the external charge.

## Patentansprüche

1. Drucksensorelement (10), umfassend ein auf einer Membran (34) angeordnetes Sensorteilelement (61), wobei das Element Folgendes umfasst:
eine Durchkontaktierung (63) und eine zwischen dem Teilelement und der Durchkontaktierung angeordnete Zwischenverbindung (62),
eine über dem Teilelement, der Durchkontaktierung und der Zwischenverbindung angeordnete Feldabschirmung (70), wobei die Feldabschirmung konfiguriert ist, um einen Einfluss einer statischen Aufladung auf das Teilelement während des Betriebs zu verringern,
eine Feldabschirmschaltung, die konfiguriert ist, um durch Anlegen eines Potenzials an ein Substrat der Membran und die Feldabschirmung einen Einfluss externer Ladung auf das Teilelement während des Betriebs im Wesentlichen zu eliminieren,
einen Hochdruckanschluss (104) und einen Niederdruckanschluss (105), die an entgegengesetzte Seiten der Membran gekoppelt sind, wobei der Niederdruckanschluss über ein Ölreservoir (106) an eine einer Druckumgebung entgegengesetzte Seite der Membran gekoppelt ist, und eine zwischen der Feldabschirmung und dem Teilelement angeordnete Passivierungsschicht (19, 20).

2. Sensorelement nach Anspruch 1, wobei das Teilelement mindestens ein piezoresistives Element umfasst.

3. Sensorelement nach Anspruch 1, wobei das Teilelement in die Membran (34) implantiert ist.

4. Sensorelement nach Anspruch 1, wobei die Feldabschirmung konfigurierbar ist, um einen Einfluss einer statischen Aufladung innerhalb des Sensorelements zu verringern.

5. Sensorelement nach Anspruch 1, wobei die Feldabschirmung durch Abscheidung und Fotolithografie über dem Teilelement angeordnet ist.

6. Sensorelement nach Anspruch 1, wobei Quellen der externen Ladung Öl, in welchem das Sensorelement zumindest teilweise versenkt ist, und/oder andere das Sensorelement umgebende Komponenten umfassen.

7. Drucksensor, umfassend:
das Drucksensorelement nach einem der Ansprüche 1 bis 6 und
einen Anschluss, um das Drucksensorelement einer Druckumgebung auszusetzen.

8. Drucksensor nach Anspruch 7, umfassend einen weiteren Anschluss und ein weiteres Drucksensorelement.

9. Drucksensor nach Anspruch 8, wobei eine Oberseite der Membran und eine Rückseite des Anschlusses durch ein Ölreservoir gekoppelt sind.

10. Drucksensor nach Anspruch 8, wobei Messungen eines Differenzdrucks einen Bereich zwischen etwa 0,2 bar und 1 bar umfassen.

11. Drucksensor nach Anspruch 8, welcher zum Messen eines Differenzdrucks entlang eines Venturi-Durchflussrohrs konfiguriert ist.

12. Drucksensor nach Anspruch 8, welcher zum Messen eines Luftmassenstroms konfiguriert ist.

13. Verfahren zum Herstellen eines Drucksensorelements, wobei das Verfahren Folgendes umfasst:
Auswählen eines Drucksensorelements, das ein auf einer Membran angeordnetes Sensorteilelement umfasst,
Anordnen einer Feldabschirmung über dem Teilelement, einer Durchkontaktierung und einer zwischen dem Teilelement und der Durchkontaktierung angeordneten Zwischenverbindung, wobei die Feldabschirmung konfiguriert ist, um durch Betrieb einer Feldabschirmschaltung, die konfiguriert ist, um ein Potenzial an ein Substrat der Membran und die Feldabschirmung anzulegen, einen Einfluss einer statischen Aufladung auf das Teilelement während des Betriebs zu verringern,
Anordnen einer Passivierungsschicht zwischen der Feldabschirmung und dem Teilelement und
Bilden eines Hochdruckanschlusses und eines Niederdruckanschlusses, die an entgegengesetzte Seiten der Membran gekoppelt werden, wobei der Niederdruckanschluss über ein Ölreservoir an eine der Druckumgebung entgegengesetzte Seite der Membran gekoppelt wird.

14. Verfahren nach Anspruch 13, umfassend Abdecken der Zwischenverbindung, der Durchkontaktierung und des Teilelements mit einer metallischen (oder elektrisch leitenden) Zusammensetzung, um den Einfluss der externen Ladung zu begrenzen.

## Revendications

1. Elément de détection de pression (10) comprenant un élément secondaire de détection (61) disposé sur une membrane (34), l'élément comprenant :
un trou d'interconnexion de contact (63), et une interconnexion (62) disposée entre l'élément secondaire et le trou d'interconnexion de contact ;
un blindage de champ (70) disposé sur l'élément secondaire, le trou d'interconnexion de contact et l'interconnexion, le blindage de champ étant configuré pour réduire l'influence de l'accumulation de charge sur l'élément secondaire pendant le fonctionnement ;
un circuit de blindage de champ configuré pour éliminer sensiblement l'influence d'une charge externe sur l'élément secondaire pendant le fonctionnement en appliquant un potentiel à un substrat de la membrane et au blindage de champ ;
un orifice à haute pression (104) et un orifice à basse pression (105) accouplés aux côtés opposés de la membrane, l'orifice à basse pression étant accouplé par l'intermédiaire d'un réservoir (106) d'huile à un côté de la membrane opposé à un environnement de pression ; et
une couche de passivation (19, 20) disposée entre le blindage de champ et l'élément secondaire.

2. Elément de détection selon la revendication 1, dans lequel l'élément secondaire comprend au moins un élément piézorésistif.

3. Elément de détection selon la revendication 1, dans lequel l'élément secondaire est implanté dans la membrane (34).

4. Elément de détection selon la revendication 1, dans lequel le blindage de champ peut être configuré pour réduire l'influence de l'accumulation de charge dans l'élément de détection.

5. Elément de détection selon la revendication 1, dans lequel le blindage de champ est disposé sur l'élément secondaire par dépôt et photolithographie.

6. Elément de détection selon la revendication 1, dans lequel les sources de la charge externe comprennent au moins de l'huile dans laquelle l'élément de détection est au moins partiellement immergé et d'autres composants entourant l'élément de détection.

7. Capteur de pression comprenant :
l'élément de détection de pression selon l'une quelconque des revendications 1 à 6 ; et
un orifice pour exposer l'élément de détection de pression à un environnement de pression.

8. Capteur de pression selon la revendication 7, comprenant un autre orifice et un autre élément de détection de pression.

9. Capteur de pression selon la revendication 8, dans lequel un côté supérieur de la membrane et un côté arrière de l'orifice sont accouplés par un réservoir d'huile.

10. Capteur de pression selon la revendication 8, dans lequel les mesures de pression différentielle couvrent une plage entre environ 0,2 bar et 1 bar.

11. Capteur de pression selon la revendication 8 configuré pour mesurer la pression différentielle à travers un tube d'écoulement Venturi.

12. Capteur de pression selon la revendication 8 configuré pour mesurer le débit massique de l'air.

13. Procédé pour fabriquer un élément de détection de pression, le procédé comprenant :
la sélection d'un élément de détection de pression comprenant un élément secondaire disposé sur une membrane ;
la disposition d'un blindage de champ sur l'élément secondaire, un trou d'interconnexion de contact et une interconnexion disposée entre l'élément secondaire et le trou d'interconnexion de contact, le blindage de champ étant configuré pour réduire l'influence de l'accumulation de charge sur l'élément secondaire pendant le fonctionnement par la mise en œuvre d'un circuit de blindage de champ configuré pour appliquer un potentiel à un substrat de la membrane et au blindage de champ ;
la disposition d'une couche de passivation entre le blindage de champ et l'élément secondaire ; et
la formation d'un orifice à haute pression et d'un orifice à basse pression accouplés aux côtés opposés de la membrane, l'orifice à basse pression étant accouplé par l'intermédiaire d'un réservoir d'huile à un côté de la membrane opposé à l'environnement de pression.

14. Procédé selon la revendication 13, comprenant le recouvrement de l'interconnexion, du trou d'interconnexion de contact et de l'élément secondaire avec une composition métallique (ou électriquement conductrice) pour limiter l'influence de la charge externe.
